(19) Europäisches Patentamt
European Patent Office
Office européen des brevets

(11) Publication number : 0 457 294 B1

(12) # EUROPEAN PATENT SPECIFICATION

(45) Date of publication of patent specification : **02.11.95 Bulletin 95/44**

(51) Int. Cl.$^{6}$ : **G01R 29/08**

(21) Application number : **91107843.4**

(22) Date of filing : **15.05.91**

(54) **Electromagnetic field analyzer for devices in which electromagnetic field is present near conductor and electric charge moves in the electromagnetic field, and method of analyzing electromagnetic field.**

(30) Priority : **16.05.90 JP 127365/90**

(43) Date of publication of application : **21.11.91 Bulletin 91/47**

(45) Publication of the grant of the patent : **02.11.95 Bulletin 95/44**

(84) Designated Contracting States : **DE FR GB**

(56) References cited :
**WO-A-90/12413**
**SU-A- 542 266**
**SU-A- 656 128**
**SU-A- 693 476**
**SU-A- 752 552**

(73) Proprietor : **MATSUSHITA ELECTRIC INDUSTRIAL CO., LTD.**
**1006, Oaza Kadoma**
**Kadoma-shi, Osaka-fu, 571 (JP)**

(72) Inventor : **Sakiyama, Kazuyuki**
**Domir Moriguchi 102,**
**78-14, Oedahigashi-machi**
**Moriguchi shi Osaka 570 (JP)**
Inventor : **Ahagon, Akira**
**Shoeiryo,**
**30-23, Miyukihigashi-machi**
**Neyagawa-shi, Osaka 572 (JP)**
Inventor : **Kotera, Hidetoshi**
**2-5-8, Uenosaka**
**Toyonaka-shi, Osaka 560 (JP)**
Inventor : **Kita, Hiromi**
**806-3, Shijo-cho**
**Kashihara-shi, Nara 634 (JP)**

(74) Representative : **Patentanwälte Beetz - Timpe - Siegfried Schmitt-Fumian - Mayr**
**Steinsdorfstrasse 10**
**D-80538 München (DE)**

EP 0 457 294 B1

Note : Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

Jouve, 18, rue Saint-Denis, 75001 PARIS

## Description

The present invention relates to an electromagnetic field analyzer and an electromagnetic field analyzing method for electromagnetic fields being present near a conductor and wherein electric charge moves in the electromagnetic field. The invention may be used for electromagnetic wave oscillators such as klystrons and magnetrons.

As a general method of analyzing the motion of the electric charge (or electron) in an electromagnetic field is known an analytical method such as a method for analyzing the trajectory of the electric charge in an electromagnetic field not changing with respect to time (N.J. Diserens, "A space charge beam option for the PE2D and TOSCA packages", IEEE Transactions on Magnetics, Vol. Mag-18, No. 2, March 1982).

Also, as an analytical method used to analyze the operation of electromagnetic wave oscillators is known another method such as that of analyzing every moment an electromagnetic field changing with respect to time in an unloaded condition and using the results to analyze the motion of the electric charge therein (J. Rodney M. Vaughan, "A model for calculation of magnetron performance", IEEE Transactions on Electron Devices, Vol. ED-20, No. 9, September 1973).

However, in the above-mentioned methods, no electromagnetic field analysis can be performed taking into account the effect of the load resistance applied to the electromagnetic wave oscillators when operated. That is, load resistance when the electromagnetic wave oscillator is operated affects the motion of the electric charge in the oscillator. Such phenomenon cannot also be analyzed.

Prior art document SU-A-656 128 discloses a travelling wave tube magnetic periodic focusing system. A step of testing the axial field of the system is followed by an additional stabilization before a corresponding correction is applied. This system relates to methods for producing magnetic periodical focusing systems for forming and stabilizing charged particle fluxes and can be used in assembling and adjusting the axial magnetic field distribution for travelling wave tubes. The axial magnetic field strength at which each magnet is additionally stabilized is given by a certain equation.

Prior art document SU-A-692 476 discloses a method for travelling wave tube retardation system measurement. The method is suitable for parameter measurement for microwave electrical vacuum devices in real operating conditions. The maximum and the minimum anode voltages at which the travelling wave tuve power output falls are measured. If the static volt-ampere-characteristics is known, the beam area, the frequency and the retardation are known. The output power as a function of beam voltage is given by two simultaneous equations. The solution of these equations gives the dispersion factor and the coupling resistance.

The object of the present invention is to provide an electromagnetic field analyzer capable of performing the compound analyses of both electric charge motion and electromagnetic field taking into account the effect of the load resistance applied to the electromagnetic field.

This object is solved in accordance with the features of the independent claims. Dependent claims are directed on preferred embodiments of the invention.

An electromagnetic field analyzer for devices in which an electromagnetic field is present near a conductor and an electric charge (electron) moves in the electromagnetic field of the present invention, comprises

input means for setting an initial condition for electric charge motion analysis and an boundary condition for electromagnetic field analysis,

electric charge motion analysis means for analyzing a position and velocity of an electric charge at a specific time based on data inputted from the input means,

magnetic field analysis means for determining a distribution of a magnetic field by utilizing results obtained by the electric charge motion analysis means,

equivalent current analysis means for determining intensity of a magnetic field at a position where an equivalent resistance to deal equivalently with a load resistance applied to the electromagnetic field is arranged on a boundary of an analytical region by utilizing results obtained by the magnetic field analysis means, and to determine a current flowing through the equivalent resistance from the boundary condition at the conductor surface,

voltage drop analysis means for determining a voltage drop across the equivalent resistance based on the current flowing through the equivalent resistance obtained from the equivalent current analysis means,

electric field intensity analysis means for analyzing an electric field intensity at the load resistance position based on results analyzed by the voltage drop analysis means,

electric field analysis means for determining an electric field based on informations obtained by the electric field intensity analysis means, and

control means for repeating drives of all or part of the each means by following a time lapsing based on results analyzed thereby.

In order to take into account the effect of the load resistance applied to an electromagnetic field in analyzing an electromagnetic wave oscillator by compounding electromagnetic field analysis and electric charge motion analysis, the present invention arranges a resistance equivalent to the load resistance in an analytical region, and converts the voltage applied to the load and the current flowing therein into an electric field and a magnetic field components to analyze the electromagnetic field distribution of the entire analytical region. The motion of an electrical charge is analyzed taking into account the force applied to the electric charge by the electromagnetic field distribution. Such compound analyses of both electric charge motion and electromagnetic field are alternately and repeatedly performed by a large-size electronic analyzer.

Thus, the present invention can analyze quantitatively the electromagnetic field distribution and the electric charge motion every moment in an electromagnetic wave oscillator when the oscillator operates while being subjected to a load, and accordingly, is an analyzer adapted for actual devices.

Fig. 1 is a block diagram showing an electromagnetic field analyzer of one embodiment in the present invention;

Fig. 2 is a flowchart showing the operation of the embodiment;

Fig. 3 is a typical view, partially in cross-section, of a magnetron in the embodiment; and

Fig. 4 is a conceptual view showing the modeling of the load resistance in a portion of the magnetron.

With reference to drawings, embodiments of the present invention are explained hereinafter.

Fig. 1 is a block diagram showing an electromagnetic field analyzer in one embodiment of the present invention.

Fig. 3 is a view of a magnetron analyzed by utilizing of the electromagnetic field analyzer. A voltage has been applied between an anode 30 forming a resonance section 32 and a cathode 31. An equivalent load resistance 34 is put in a place where an antenna is present. A magnetic field has been applied perpendicularly to the sheet surface.

When an electric charge flies out of the cathode 31, an electric field is changed accordingly, and a magnetic field is also changed. At the same time, a current 33 flows in synchronism with the motion of the electric charge 35 along the anode 30. The presence of the load resistance 34 causes a voltage drop to be developed. The synchronization of the current with the electric charge is deviated accordingly.

Under such circumstance, the electromagnetic field analyzer of the present invention performs analysis.

That is, input means 1 for setting the initial condition for electric charge motion analysis and the boundary condition for electromagnetic field analysis is, for example, a keyboard.

Electric charge motion analysis means 2 is used to analyze the position and velocity of an electric charge at a time t. With the position and velocity of the electric charge obtained therefrom, an electric charge density distribution $\rho$ and a current density distribution J are determined.

Magnetic field analysis means 3 is used to solve the wave equation for magnetic field shown in the following equation (1) by use of the finite element method so as to determine the distribution of a magnetic field H.

$$\nabla^2 H - \mu\varepsilon \frac{\partial^2 H}{\partial t^2} = -\mathrm{rot} J \quad (1)$$

As another method of analyzing the magnetic field distribution, the difference calculus or the boundary element method can also be used.

Fig. 4 is a view modeling the magnetron in Fig. 3. That is, when a resistance model to deal equivalently with the load resistance applied to the electromagnetic field is arranged on the boundary of an analysis region as shown in Fig. 4, an equivalent current analysis means 4 is used to determine the intensity of the magnetic field at the arranged position by utilizing the results obtained by the magnetic field analysis means 3, and to determine a current i flowing through the resistance from the boundary condition at a conductor surface shown in the equation (2), as shown in the equation (3).

$$Ht = k \quad (2)$$

$$i = k\,hr \quad (3)$$

where Ht is the tangential component of the magnetic field to the boundary, k is the face current density of the induced current at the boundary, and hr is width through which the induced current flows. The boundary is not always the surface of the anode 30, it may be somewhat inside the anode.

A voltage drop analysis means 5 is used to determine a voltage drop Vr across the equivalent load resistance by the equation (4) based on the current i flowing through the equivalent load resistance, obtained from the equivalent current analysis means 4.

$$Vr = zi \quad (4)$$

Where z is the impedance of the equivalent load resistance.

An electric field intensity analysis means 6 is used to analyze the electric field intensity at the load resistance position, whereby a tangential electric field Et determined by the equation (5) can be obtained at the boundary position taking into account the load for the equivalent load resistance.

$$Et = Vr/lr \quad (5)$$

Where lr is the distance across the position where the equivalent resistance is arranged.

For example, where the boundary subjected to the load is a conductor, Vr = 0 is an unloaded condition from (4), whereby the tangential component Et of the electric field is zero, and thus no effect of the load resistance appears on the electromagnetic field. On the contrary, in a loaded condition, said Et affects the electric field distribution in the analytical region. An electric field analysis means 7 is used to determine an electric field, and it can take into account the fact by incorporating said Et in the boundary condition to analyze the electric field. To analyze an electric field E, the wave equation with respect to electric field shown in the following equation (6) is used, and then the electric field distribution can be obtained by the finite element method.

$$\nabla^2 E - \mu\varepsilon \frac{\partial^2 E}{\partial t^2} = \frac{l}{\varepsilon}\text{grad } \rho + \mu \frac{\partial J}{\partial t} \quad (6)$$

A control means 8 is used to control the drive of all or part of the above-mentioned means, for example, to repeat the operation of the magnetic field analysis means 2 and the following means by following the time lapsing. This allows the analytical information on the motion of the electric charge in the electromagnetic field affected by the load resistance to be obtained.

The operation of the above-mentioned embodiment will be explained hereinafter.

Fig. 2 is a flowchart showing the operation of the analyzer in the embodiment. The double box in Fig. 3 indicates the flow of calculation.

The step (A) is an input step for setting the initial condition for electric motion analysis. The step (B) is an input step for setting the boundary condition for electro-magnetic field analysis.

In the step (C), the analysis time is advanced by a variation $\delta t$ for time integration analysis.

In the step (D), a processing is performed to obtain the position and velocity of the electric charge at a time t. From the position and velocity of the electric charge obtained therein, the electric charge density distribution $\rho$ and the current density distribution J are converted. In the step (E), the wave equation for magnetic field shown in the above-mentioned equation (1) is solved by use of the finite element method to determine the information on the distribution of the magnetic field H.

In the step (F), when a resistance model to deal equivalently with the load resistance applied to the electromagnetic filed is arranged on the boundary on an analytical region as shown in Fig. 4, the intensity of the magnetic field at the position is determined from the analyzed results of the step (E), and the current i flowing through the resistance is obtained from the boundary condition at the conductor surface shown in said equation (2), as shown in said equation (3).

Since the current i flowing through the equivalent load resistance can be thus determined, the voltage drop Vr across the equivalent load resistance is obtained by said equation (4) in step (G).

Accordingly, in the step (H), the tangential electric field Et determined by said equation (5) develops at the boundary position taking into account the load for the equivalent load resistance.

For example, where the boundary subjected to the load is a conductor, Vr = 0 in an unloaded condition by said equation (4), whereby the tangential component Et of the electric field is zero, and thus no effect of the load resistance appears on the electromagnetic field. On the contrary, in a loaded condition, said Et affects the electric field distribution in the analytical region. The fact can be taken into account by incorporating said Et in the boundary condition to analyze the electric field in the step (I). To analyze an electric field E, the wave equation with respect to electric field shown in equation (6) is used, and then the electric field distribution is obtained by the finite element method.

Further, by returning the analysis back to the step (C) to repeat the analysis by following the time lapsing, there can be performed the analysis of the motion of the electric charge in the electromagnetic field affected by the load resistance, and the analysis of the electric field and magnetic field.

Although each means of the present invention may be implemented in software or firmware by using a computer, of course they may be implemented by using a special hardware circuit.

As explained previously, according to the present invention, the operation of an electromagnetic wave oscillator in a loaded condition can be analyzed, whereby the motion of an electric charge in the oscillator can be quantitatively analyzed.

While the preferred form of the present invention has been described, it is to be understood that modifications will be apparent to those skilled in the art within the scope of the invention as defined in the Claims.

## Claims

1. An electromagnetic field analyzer for devices in which an electromagnetic field is present near a conductor and an electric charge moves in the electromagnetic field, comprising:
input means (1) for setting an initial condition for electric charge motion analysis and a boundary condition for electromagnetic field analysis;
electric charge motion analysis means (2) for analyzing a position and velocity of an electric charge at a specific time based on data inputted from said input means (1),
magnetic field analysis means (3) for determining a distribution of a magnetic field by utilizing results obtained by said electric charge motion analysis means (2);
equivalent current analysis means (4) for determining intensity of a magnetic field at a position where an equivalent resistance (34) to deal equivalently with a load resistance applied to the electromagnetic field is arranged on a boundary of an analytical region by utilizing results obtained by said magnetic field analysis means (3), and to determine a current flowing through the equivalent resistance (34) from the boundary condition at the conductor surface;
voltage drop analysis means (5) for determining a voltage drop across the equivalent resistance based on the current flowing through the equivalent resistance (34) obtained from said equivalent current analysis means (4);
electric field intensity analysis means (6) for analyzing an electric field intensity at the load resistance position based on results analyzed by said voltage drop analysis means (5);
electric field analysis means (7) for determining an electric field based on information obtained by said electric field intensity analysis means (6); and
control means (8) for repeating operation of all or part of said each means depending on results analyzed thereby and taking account of elapsed time.

2. An electromagnetic field analyzer in accordance with claim 1,
characterized in that
said electric field and/or magnetic field is analyzed by a finite element method.

3. An electromagnetic field analyzing method, where an electromagnetic field is present near a conductor and an electric charge moves in the electromagnetic field, comprising:
a step of arranging a resistance equivalent to a load resistance applied to an electromagnetic field, in an analytical region,
a step of analyzing the electromagnetic field distribution of the entire analytical region by converting a voltage applied to the load resistance and a current flowing therein into an electric field and a magnetic field component,
a step of analyzing a motion of an electrical charge moving the electric field, taking into account a force applied to the electric charge by the electromagnetic field distribution,
a step of alternately and repeatedly performing such compound analyses of both electric charge motion and electromagnetic field distribution.

4. A method according to claim 3,
characterized in that
a finite element method is used as a method of analyzing the electromagnetic field, and in order to take into account an effect of the load resistance on the electromagnetic field in the finite element method, a resistance equivalent to said load resistance is arranged in an analytical region, whereby a relationship between an electric field and a magnetic field in an analytical region can be dealt with as an equivalent by use of a voltage and current applied to said load resistance.

5. A method according to claim 3,
characterized in that
the motion of an electric charge is analyzed by taking an electric field obtained by a voltage component applied to the resistance equivalent to a load resistance as an electric field applied to said electric charge in order to take into account an effect of the load resistance on an electromagnetic field in analyzing a motion of the electric charge in the electromagnetic field.

**Patentansprüche**

1. Analysator für elektromagnetische Felder, für Vorrichtungen, in denen das elektromagnetische Feld nahe an einem Leiter ist und eine elektrische Ladung sich in dem elektromagnetischen Feld bewegt, mit:
einem Eingabemittel (1) zum Einstellen einer Anfangsbedingung für die Analyse der Bewegung der elektrischen Ladung und einer Randbedingung für die Analyse des elektromagnetischen Feldes;
einem Ladungsbewegungsanalysemittel (2) zum Analysieren von Position und Geschwindigkeit einer elektrischen Ladung zu einem spezifischen Zeitpunkt auf Grundlage von über das Eingabemittel (1) eingegebenen Daten;
einem Magnetfeldanalysemittel (3) zum Bestimmen der Verteilung eines Magnetfelds anhand der vom Ladungsbewegungsanalysemittel (2) erhaltenen Ergebnisses;
einem Äquivalentstromanalysemittel (4) zum Bestimmen der Stärke eines Magnetfelds an einer Position, an der ein Äquivalentwiderstand (34) zur äquivalenten Verarbeitung eines auf das elektromagnetische Feld wirkenden Lastwiderstands an einem Rand eines Analysebereichs angeordnet ist, unter Verwendung von vom Magnetfeldanalysemittel (3) erhaltenen Ergebnissen, und zum Bestimmen eines durch den Äquivalentwiderstand (34) fließenden Stroms aus der Randbedingung an der Leiteroberfläche;
einem Spannungsabfallanalysemittel (5) zum Bestimmen eines Spannungsabfalls über dem Äquivalentwiderstand auf Grundlage des durch den Äquivalentwiderstand (34) fliessenden Stroms, der vom Äquivalentstromanalysemittel (4) erhalten wird;
einem Feldstärkeanalysemittel (6) zum Analysieren einer elektrischen Feldstärke an der Position des Lastwiderstands auf Grundlage von Analyseergebnissen des Spannungsabfallanalysemittels (5);
einem Feldanalysemittel (7) zum Bestimmen eines elektrischen Feldes auf Grundlage von vom Feldstärkeanalysemittel (6) erhaltener Information; und
einem Steuermittel (8) zum Wiederholen des Betriebs aller oder einiger der genannten Mittel in Abhängigkeit von den erhaltenen Analyseergebnissen und unter Berücksichtigung der verstrichenen Zeit.

2. Feldanalysator nach Anspruch 1,
dadurch gekennzeichnet, daß
das elektrische und/oder magnetische Feld durch eine Finite-Elemente-Methode analysiert wird.

3. Verfahren zum Analysieren eines elektromagnetischen Feldes, wobei das elektromagnetische Feld in der Nähe eines Leiters liegt und eine elektrische Ladung sich im elektromagnetischen Feld bewegt, mit:
einem Schritt des Anordnens eines zu einem auf das elektromagnetische Feld wirkenden Lastwiderstands äquivalenten Widerstands in einem Analysebereich,
einem Schritt des Analysierens der Verteilung des elektromagnetischen Feldes im gesamten Analysebereich durch Konvertieren einer am Lastwiderstand anliegenden Spannung und eines daran fließenden Stromes in eine elektrische und eine magnetische Feldkomponente,
einem Schritt des Analysierens einer sich im elektrischen Feld bewegenden Ladung unter Berücksichtigung einer durch die Verteilung des elektromagnetischen Feldes auf die elektrische Ladung wirkenden Kraft;
einem Schritt des wiederholten, abwechselnden Durchführens solcher kombinierter Analysen sowohl der Bewegung der elektrischen Ladung als auch der Verteilung des elektromagnetischen Feldes.

4. Verfahren nach Anspruch 3,
dadurch gekennzeichnet, daß
eine Finite-Elemente-Methode als Methode zum Analysieren des elektromagnetischen Feldes verwendet wird und daß zum Berücksichtigen der Wirkung des Lastwiderstands auf das elektromagnetische Feld bei der Finite-Elemente-Methode ein dem Lastwiderstand äquivalenter Widerstand in einem Analysebereich angeordnet wird, wodurch eine Beziehung zwischen elektrischem Feld und magnetischem Feld in einem Analysebereich durch Verwendung einer Spannung und eines Stroms, die an den Lastwiderstand angelegt werden, äquivalent verarbeitet werden kann.

5. Verfahren nach Anspruch 3,
dadurch gekennzeichnet, daß
die Bewegung einer elektrischen Ladung analysiert wird, indem ein durch Anlegen einer Spannungskomponente an den einem Lastwiderstand äquivalenten Widerstand erhaltenes elektrisches Feld als auf die elektrische Ladung wirkendes elektrisches Feld angenommen wird, um die Wirkung des Lastwiderstands auf ein elektromagnetisches Feld beim Analysieren der Bewegung einer elektrischen Ladung im elektromagnetischen Feld zu berücksichtigen.

## Revendications

1. Un analyseur de champ électromagnétique pour des dispositifs dans lesquels un champ électromagnétique est présent au voisinage d'un conducteur et une charge électrique se déplace dans le champ électromagnétique, comprenant :
des moyens d'entrée (1) pour fixer une condition initiale pour l'analyse du mouvement d'une charge électrique et une condition limite pour l'analyse du champ électromagnétique;
des moyens d'analyse de mouvement de charge électrique (2) pour analyser une position et une vitesse d'une charge électrique à un moment spécifique sur la base de données introduites par les moyens d'entrée (1);
des moyens d'analyse de champ magnétique (3) pour déterminer une distribution d'un champ magnétique par l'utilisation des résultats obtenus par les moyens d'analyse de mouvement de charge électrique (2);
des moyens d'analyse de courant équivalent (4) pour déterminer l'intensité d'un champ magnétique à une position à laquelle une résistance équivalente (34) pour prendre en considération de façon équivalente une résistance de charge appliquée au champ électromagnétique, est disposée sur une limite d'une région d'analyse, par l'utilisation de résultats obtenus par les moyens d'analyse de champ magnétique (3), et pour déterminer un courant qui circule à travers la résistance équivalente (34), à partir de la condition limite à la surface du conducteur;
des moyens d'analyse de chute de tension (5) pour déterminer une chute de tension à travers la résistance équivalente, sur la base du courant qui circule dans la résistance équivalente (34), obtenu par les moyens d'analyse de courant équivalent (4);
des moyens d'analyse d'intensité de champ électrique (6) pour analyser une intensité de champ électrique à la position de la résistance de charge, sur la base de résultats analysés par les moyens d'analyse de chute de tension (5);
des moyens d'analyse de champ électrique (7) pour déterminer un champ électrique sur la base de l'information qui est obtenue par les moyens d'analyse d'intensité de champ électrique (6); et

des moyens de commande (8) pour répéter le fonctionnement de la totalité ou d'une partie de chacun des moyens précités, sous la dépendance des résultats analysés par ceux-ci, et qui tiennent compte du temps écoulé.

2. Un analyseur de champ électromagnétique selon la revendication 1,
caractérisé en ce que
le champ électrique et/ou le champ magnétique est analysé par une méthode des éléments finis.

3. Un procédé d'analyse de champ électromagnétique, dans lequel un champ électromagnétique est présent au voisinage d'un conducteur et une charge électrique se déplace dans le champ électromagnétique, comprenant :
une étape qui consiste à incorporer dans une région d'analyse une résistance équivalente d'une résistance de charge qui est appliquée à un champ électromagnétique,
une étape consistant à analyser la distribution de champ électromagnétique de la totalité de la région d'analyse, en convertissant une tension appliquée à la résistance de charge et un courant circulant dans cette dernière, en un champ électrique et une composante de champ magnétique,
une étape consistant à analyser un mouvement d'une charge électrique se déplaçant dans le champ électrique, en tenant compte d'une force appliquée à la charge par la distribution de champ électromagnétique, et
une étape consistant à accomplir alternativement et de façon répétée de telles analyses combinées du mouvement de la charge électrique et de la distribution du champ électromagnétique.

4. Un procédé selon la revendication 3,
caractérisé en ce que
on utilise une méthode des éléments finis à titre de méthode d'analyse du champ électromagnétique, et dans le but de tenir compte d'un effet de la résistance de charge sur le champ électromagnétique dans la méthode des éléments finis, on incorpore dans une région d'analyse une résistance équivalente de la résistance de charge précitée, grâce à quoi on peut traiter d'une manière équivalente une relation entre un champ électrique et un champ magnétique dans une région d'analyse, par l'utilisation d'une tension et d'un courant appliqués à la résistance de charge.

5. Un procédé selon la revendication 3,
caractérisé en ce que
on analyse le mouvement d'une charge électrique en prenant pour un champ électrique appliqué à la charge électrique, un champ électrique qui est obtenu par une composante de tension appliquée à la résistance équivalente d'une résistance de charge, afin de tenir compte d'un effet de la résistance de charge sur un champ électromagnétique dans l'analyse du mouvement de la charge électrique dans le champ électromagnétique.

FIG. 1

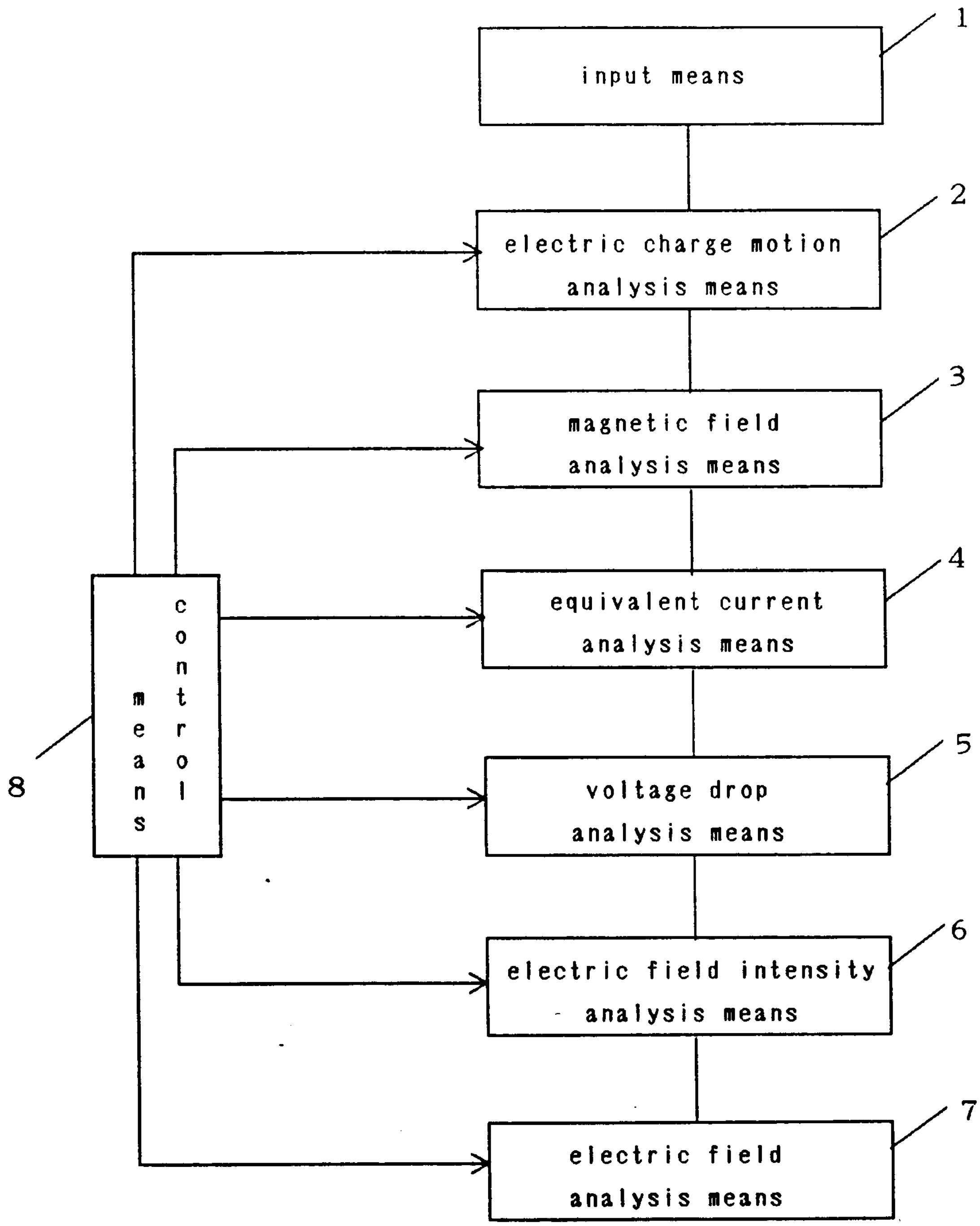
input means
electric charge motion analysis means
magnetic field analysis means
equivalent current analysis means
voltage drop analysis means
electric field intensity analysis means
electric field analysis means
control means
1
2
3
4
5
6
7
8

F I G. 2

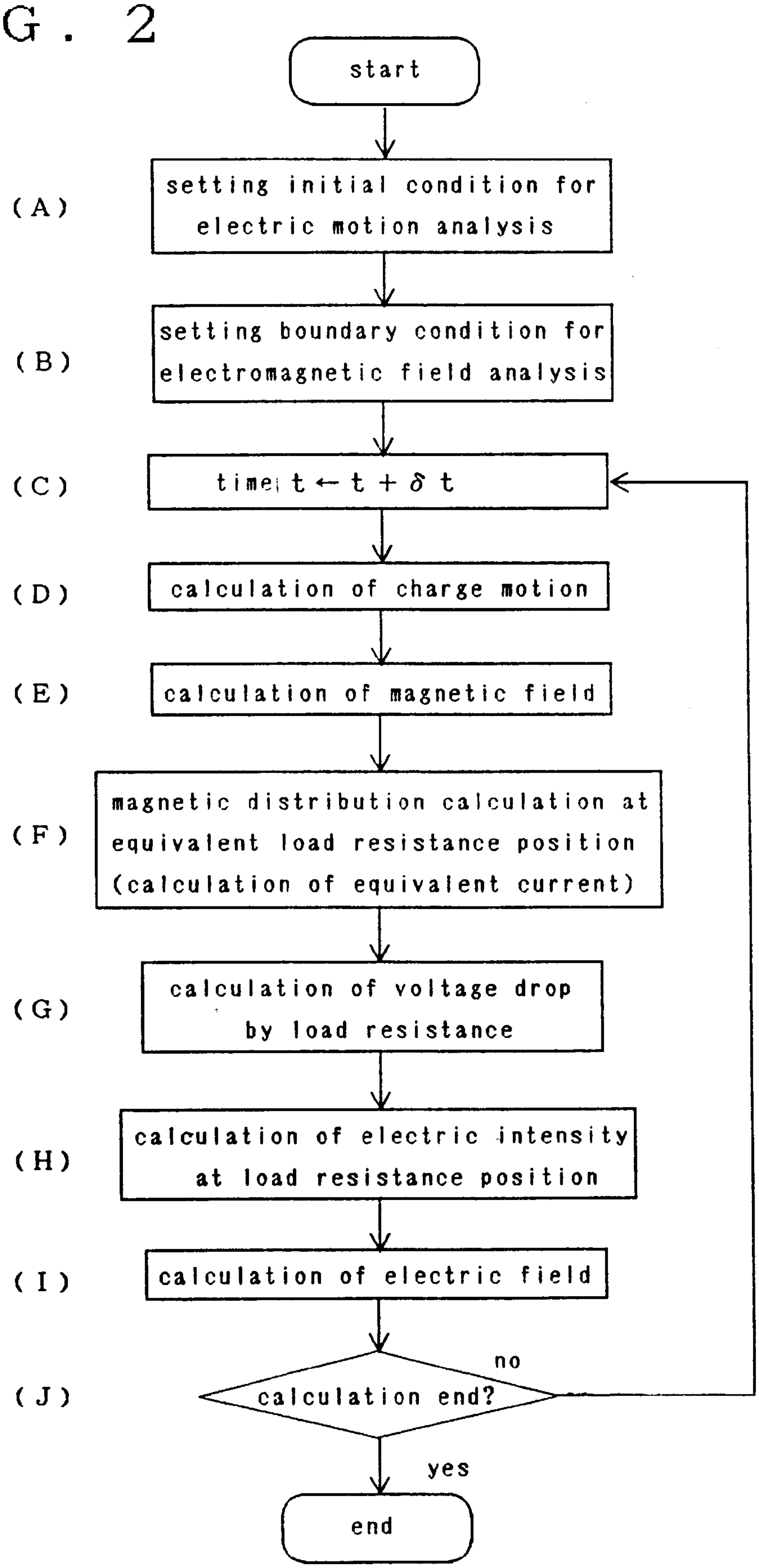
start
(A)
setting initial condition for electric motion analysis
(B)
setting boundary condition for electromagnetic field analysis
(C)
time; t ← t + δ t
(D)
calculation of charge motion
(E)
calculation of magnetic field
(F)
magnetic distribution calculation at equivalent load resistance position (calculation of equivalent current)
(G)
calculation of voltage drop by load resistance
(H)
calculation of electric intensity at load resistance position
(I)
calculation of electric field
(J)
calculation end?
no
yes
end

FIG. 3

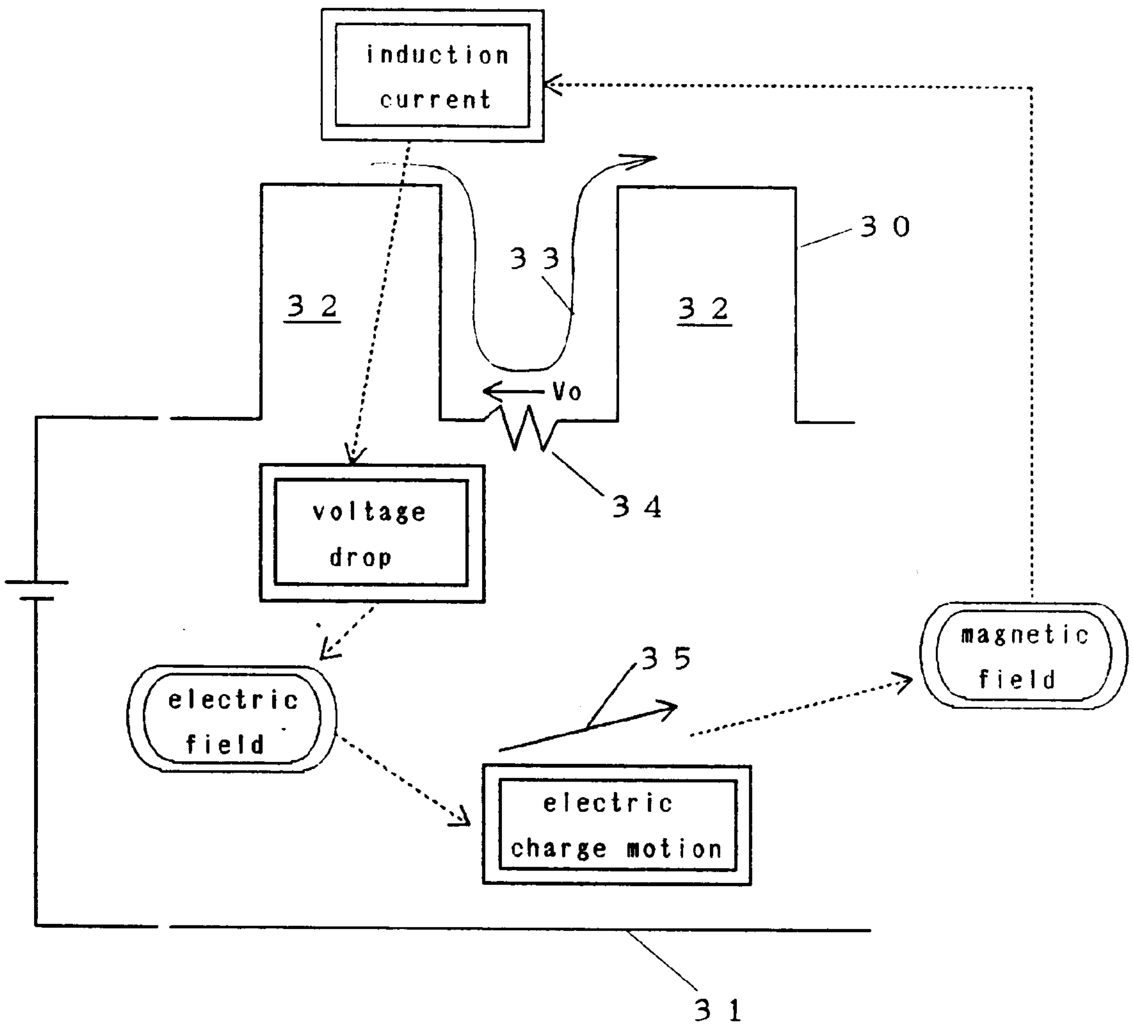
induction current
30
33
32
32
Vo
34
voltage drop
35
magnetic field
electric field
electric charge motion
31

FIG. 4

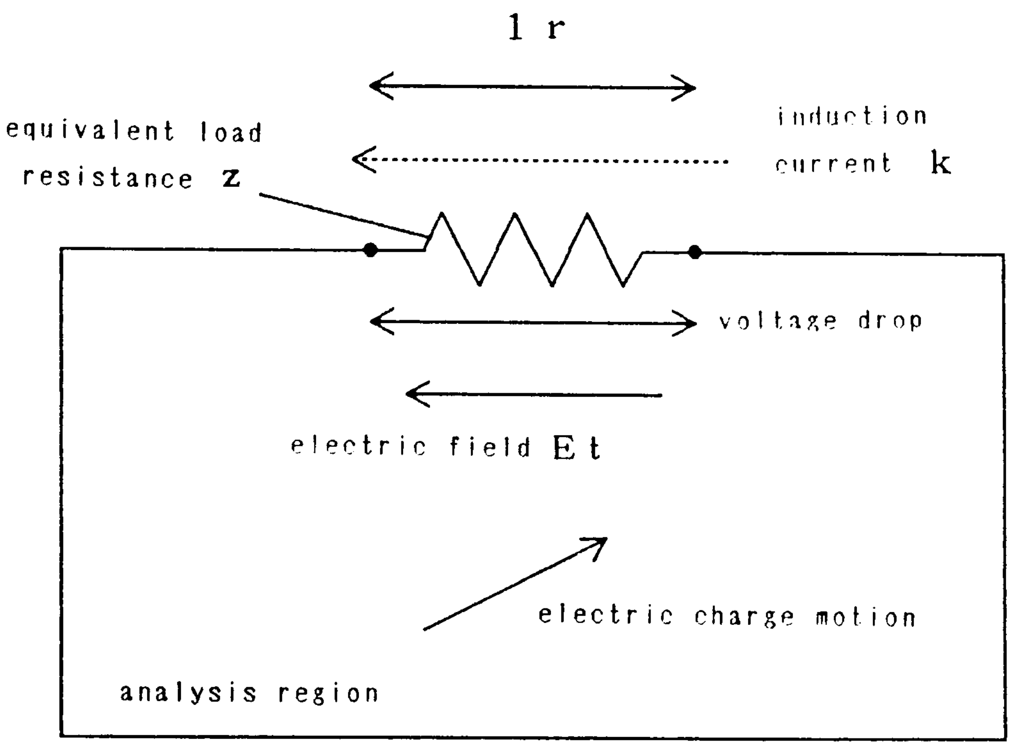
1 r
equivalent load
resistance z
induction
current k
voltage drop
electric field Et
electric charge motion
analysis region